# EUROPEAN PATENT APPLICATION

(11) **EP 3 057 135 A1**
(43) Date of publication of application: **17.08.2016**
(21) Application number: 15179872.5
(22) Date of filing: 05.08.2015
(51) Int. Cl.: H01L 31/0224, H01L 31/05

(54) **PHOTOVOLTAIC MODULE AND METHOD FOR PRODUCING THE SAME**

(30) Priority: 16.02.2015 CN 201510086349; 16.02.2015 CN 201510086350
(71) Applicant: Baoding Yitong PV Science & Technology Co., Ltd., Baoding Hebei 071000 (CN)
(72) Inventor: Wang, Ke, 071000 Baoding (CN)
(74) Representative: Johnson, Richard Alan

(57) **Abstract**

According to some embodiments in the disclosure, there is provided a photovoltaic module, including a cell slice and a photovoltaic ribbon (2). The cell slice has a plurality of thin gate lines on one side. The photovoltaic ribbon includes a metal substrate (21), a conductive coating layer (23) and an alloy layer (22) that is sandwiched between the metal substrate and the conductive coating layer. The conductive coating layer of the photovoltaic ribbon is in direct contact with the thin gate lines. The photovoltaic cell according to the embodiments omits the main gate line, and the thin gate lines are electrically connected to the photovoltaic ribbon by directly welding the thin gate lines with the photovoltaic ribbon.

## Description

### TECHNICAL FIELD

The present disclosure relates to the technical field of photovoltaic cell, and in particular to a photovoltaic module and a method for producing the photovoltaic module.

### BACKGROUND

As energy consumption becomes higher and higher, environmental problems, such as the excessive exhaust of carbon dioxide and the frequent atmospheric haze, are more and more serious. Thus, the need for green energy becomes extremely urgent. The solar energy, as a main type of the green energy, will be widely used afterwards. However, the inventor discovers that the photoelectric conversion efficiency of existing solar cells needs to be improved. Furthermore, the inventor also discovers that the breakage rate is relative high when producing the solar cells according to the conventional technology.

### SUMMARY

According to the invention, there is provided a photovoltaic module and a method for producing the photovoltaic module according to embodiments in the disclosure.

According to some embodiments in the disclosure, there is provided a photovoltaic module, including a cell slice and a photovoltaic ribbon. The cell slice has a plurality of thin gate lines on one side. The photovoltaic ribbon includes a metal substrate, a conductive coating layer and an alloy layer that is sandwiched between the metal substrate and the conductive coating layer. The conductive coating layer of the photovoltaic ribbon is in direct contact with the thin gate lines.

According to other embodiments in the disclosure, there is provided a method for producing a photovoltaic module. First, a cell slice is provided, the cell slice having a plurality of thin gate lines on one side. Then, a photovoltaic ribbon is provided, the photovoltaic ribbon including a metal substrate, a conductive coating layer and an alloy layer that is sandwiched between the metal substrate and the conductive coating layer. After that, the conductive coating layer is stuck to the thin gate lines. Then, the conductive coating layer is fused to weld the photovoltaic ribbon.

### BRIEF DESCRIPTION OF THE DRAWINGS

The accompanying drawings needed to be used in the description of the embodiments or the conventional technology will be described briefly as follows, so that the technical solutions according to the embodiments of the present disclosure or according to the conventional technology will become clearer. It is obvious that the accompanying drawings in the following description are only some embodiments of the present disclosure. For those skilled in the art, other accompanying drawings may be obtained according to these accompanying drawings without any creative work.
Figure 1 is a structural schematic diagram of the front side of a cell slice before being welded with a photovoltaic ribbon, in a photovoltaic cell according to an embodiment in the disclosure;
Figure 2 is a structural schematic diagram of a photovoltaic ribbon in a photovoltaic cell according to an embodiment in the disclosure;
Figure 3 is a structural schematic diagram of the back side of a cell slice in a photovoltaic cell according to another embodiment in the disclosure; and
Figure 4 is a structural schematic diagram of the back side of a cell slice in a photovoltaic cell according to still another embodiment in the disclosure.

### DETAILED DESCRIPTION OF EMBODIMENTS

In the conventional technology, the front side of a photovoltaic cell is covered with thin gate lines and a main gate line, the shading action of which limits the light-receiving area of the photovoltaic cell, and thus limits the photoelectric conversion efficiency of the photovoltaic cell.

In addition, the breakage of solar cell in the conventional technology mainly results from a welding process. Because most of the existing welding processes are to apply an alloy, such as an alloy of tin and lead, or an alloy of tin, silver and copper on a surface of a copper ribbon at a high welding temperature. Thus, in the welding processes, the temperature at a welded portion is higher while the temperature at a non-welded portion is lower, resulting in breakage due to a large temperature difference between the welded portion and non-welded portion on the surface of the solar cell.

According to embodiments in the disclosure, there is provided a photovoltaic module including one or more photovoltaic cells. Each of the photovoltaic cells includes a cell slice and a photovoltaic ribbon. The cell slice has a plurality of thin gate lines on one side. The photovoltaic ribbon includes a metal substrate, a conductive coating layer and an alloy layer that is sandwiched between the metal substrate and the conductive coating layer. The conductive coating layer of the photovoltaic ribbon is in direct contact with the thin gate lines.

Compared with the photovoltaic cell in the conventional technology, the photovoltaic cell according to the embodiments omits the main gate line. Therefore, the thin gate lines are electrically connected to the photovoltaic ribbon by directly welding the thin gate lines with the photovoltaic ribbon and the current in individual thin gate lines are assembled directly via the photovoltaic ribbon, thus reducing the shading area of the photovoltaic cell, increasing the light-receiving area of the photovoltaic cell, and improving the photoelectric conversion efficiency of the photovoltaic cell.

Furthermore, the photovoltaic ribbon according to the embodiments consists of the metal substrate, such as a copper substrate, the alloy layer and the conductive coating layer. The metal substrate is for current transmission, the alloy layer is for ensuring a good electric contact between the metal substrate and the conductive coating layer. Compared with the photovoltaic ribbon in the conventional technology, the conductive coating layer is added on the surface of the alloy layer to weld the photovoltaic ribbon to the thin gate lines on the surface of the photovoltaic cell slice by using the conductive coating layer. The photovoltaic ribbon according to the embodiments has a lower welding temperature than that of the photovoltaic ribbon in the conventional technology, reducing the temperature difference between the welded portion and the non-welded portion in the welding process, and thereby decreasing the breakage rate and thus the production cost of photovoltaic cells.

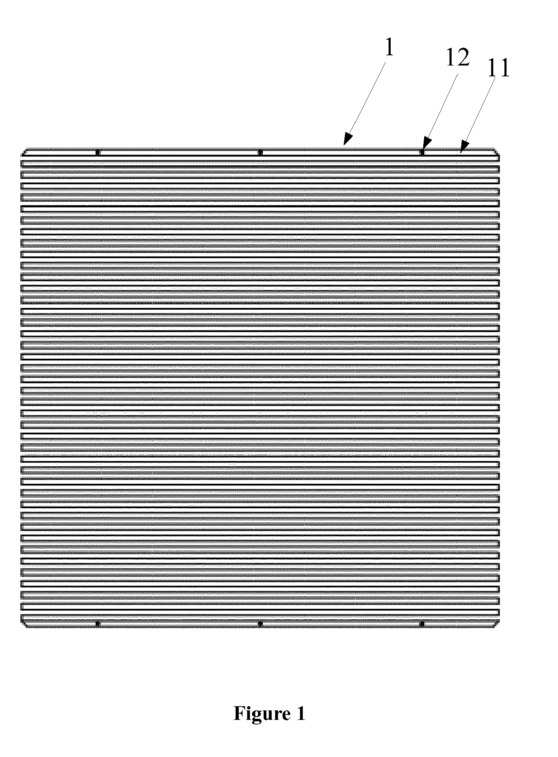

Referring to Figure 1, an example photovoltaic cell according to an embodiment in the disclosure includes a cell slice 1 having a plurality of thin gate lines 11 on the front side; and a photovoltaic ribbon 2 disposed on a side of the thin gate lines 11 opposite to the photovoltaic cell slice and welded directly with the thin gate lines 11.

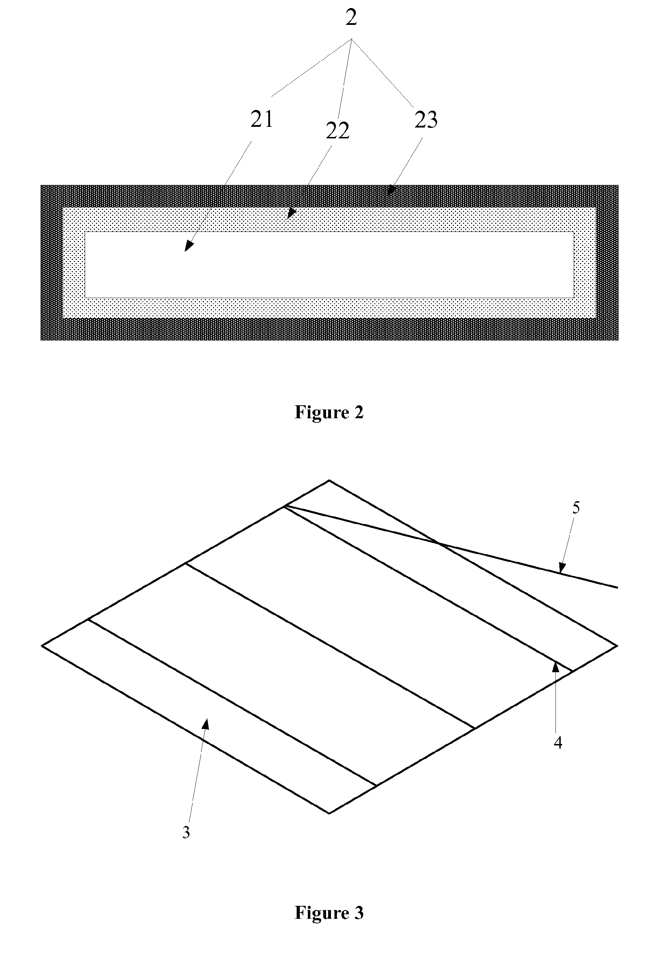

Referring to Figure 2, the photovoltaic ribbon 2 includes: a metal substrate 21, such as a copper substrate 21; an alloy layer 22 disposed on the surface of the copper substrate 21 and covering the copper substrate 21; and a conductive coating layer 23 disposed on the surface of the alloy layer 22 and covering the alloy layer 22.

The conductive coating layer 23 is directly welded with the thin gate lines 11.

According to an embodiment, the melting point of the conductive coating layer 23 is, for example, lower than the melting point of the alloy layer.

In the embodiment, the photovoltaic cell only has the thin gate lines 11 on the front side without the main gate line, turning the shading area corresponding to the main gate line in the conventional technology to a light-receiving area, and thus reducing the shading area of the photovoltaic cell and increasing the light-receiving area of the photovoltaic cell, and thus improving the photoelectric conversion efficiency of the photovoltaic cell.

It should be noted that, since the melting point of a regular alloy is relatively high and the widths of individual thin gate lines 11 are relatively small, the breakage rate is higher in producing the photovoltaic if the thin gate lines are directly welded with the photovoltaic ribbon of the conventional technology. Therefore, in the embodiment, the photovoltaic ribbon 2 including the three layers: the copper substrate 21, the alloy layer 22 and the conductive coating layer 23 is provided. The copper substrate 21 is for current transmission, the alloy layer 22 is for ensuring a good contact between the copper substrate 21 and the conductive coating layer 23, and the conductive coating layer 23 is for welding to the thin gate lines 11. The melting point of the conductive coating layer 23, for example, is lower than the melting point of the alloy layer and thus has a lower welding temperature, reducing the temperature difference between the welded portion and the non-welded portion in the welding process, and thereby decreasing the breakage rate and thus production cost of photovoltaic cells.

According to an embodiment in the disclosure, when the photovoltaic ribbon 2 is welded to the thin gate lines 11 on the surface of the photovoltaic cell slice, it is only required to first stick the conductive coating layer 23 of the photovoltaic ribbon 2 to the thin gate lines 11 on the surface of the photovoltaic cell slice and then melt the conductive coating layer 23 of the photovoltaic ribbon 2 by means of heating to achieve the substantial welding between the photovoltaic ribbon 2 and the thin gate lines 11 on the surface of the photovoltaic cell slice.

Moreover, since the main gate line is eliminated in the photovoltaic cell according to the embodiment, the corresponding amount of sliver paste for the main gate line can be avoided, reducing the amount of the sliver paste used in producing the photovoltaic cell, and further reducing the production cost of the photovoltaic cell.

Figure 3 is a structural schematic diagram of the back side of a cell slice in a photovoltaic cell according to another embodiment in the disclosure. Referring to Figure 3, the cell slice 1 has a back surface field 3 on the back side; a back electrode 4 is provided on one side of the back surface field 3 opposite to the cell slice 1; and a photovoltaic ribbon 5 is provided on one side of the back electrode 4 opposite to the back surface filed 3. The photovoltaic ribbon 5 is electrically connected to the back electrode 4, and the back electrode 4 is electrically connected to the back surface field 3.

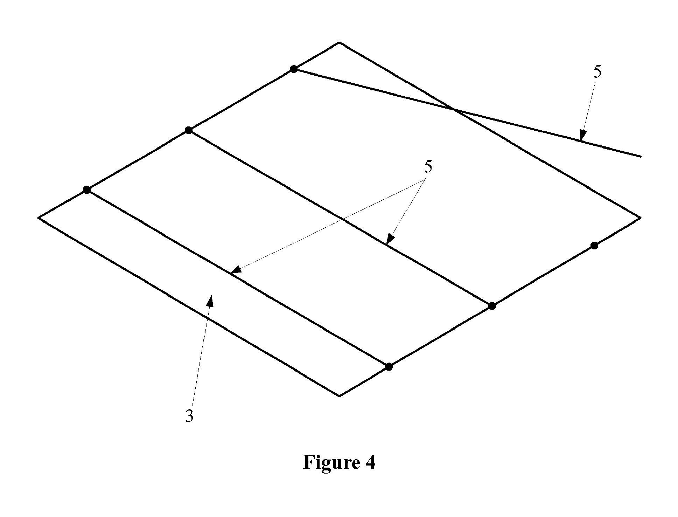

Figure 4 is a structural schematic diagram of the back side of a cell slice in a photovoltaic cell according to yet another embodiment in the disclosure. Referring to Figure 4, the cell slice 1 has a back surface field 3 on the back side; a photovoltaic ribbon 5 is provided on one side of the back surface field 3 opposite to the cell slice 1. The photovoltaic ribbon 5 is electrically connected to the back surface field 3 directly for further reducing the amount of sliver paste and the cost of the photovoltaic cell. However, the structure depends on actual requirements, and is not limited in the disclosure.

According to an embodiment, the photovoltaic ribbon 5 in Figures 3 and 4 has the same structure as that of the photovoltaic ribbon 2 in Figure 2, including a metal substrate, such as a copper substrate; an alloy layer disposed on the surface of the copper substrate and covering the copper substrate; and a conductive coating layer disposed on the surface of the alloy layer and covering the alloy layer.

According to an embodiment, the cell slice 1 has multiple welding spots 12 on the front side to replace the main gate line for locating the welding position of the photovoltaic ribbon (for example, the photovoltaic ribbon 2 and the photovoltaic ribbon 5). The cell slice 1 has, for example, six welding spots divided into 3 groups, and two welding spots in each of the groups define the position of one photovoltaic ribbon.

According to an embodiment, the welding temperature of the conductive coating layer is, for example, equal to or greater than 160°C and less than or equal to 180°C, so as to not only meet the temperature requirement for the laminating process in producing the photovoltaic cell, but also ensure a relatively low temperature to reduce the breakage rate in producing the photovoltaic cell and thus reduce the production cost of the photovoltaic cell. However, the welding temperature is not limited in the disclosure, and in other embodiments, the welding temperature of the conductive coating layer may be adjusted appropriately, as long as the breakage rate in producing the photovoltaic cell can be reduced.

It should be noted that, since the photovoltaic ribbon 2 according to the embodiments in the disclosure may be sufficiently welded with the thin gate line 11 on the front side of the photovoltaic cell at a relatively low temperature, the width of the photovoltaic ribbon 2 may be reduced, thereby reducing the shading area of the photovoltaic cell and increasing the light-receiving area of the photovoltaic cell, and thus improving the photoelectric conversion efficiency of the photovoltaic cell. The width of the photovoltaic ribbon 2 may be, for example, equal to or greater than 1.0mm and less than or equal to 1.5mm. According to an embodiment, the width of the photovoltaic ribbon 5 is, for example, the same as that of the photovoltaic ribbon 2.

In addition, according to an embodiment, the thickness of the alloy layer 22 of the photovoltaic ribbon 2 is less than the thickness of an alloy layer of a photovoltaic ribbon in the conventionally technology, and the thickness of the photovoltaic ribbon 2 is not greater than the thickness of a photovoltaic ribbon in the conventionally technology. In the photovoltaic ribbon 2, the thickness of the alloy layer 22 may be, for example, equal to or greater than 0.02mm and less than or equal to 0.03mm; and thickness of the conductive coating layer 23 may be, for example, equal to or greater than 0.01mm and less than or equal to 0.02mm. However, the thicknesses depend on actual requirements, and are not limited in the disclosure. According to an embodiment, the thicknesses of the alloy layer and the conductive coating layer of the photovoltaic ribbon 5 are, for example, the same as those of the photovoltaic ribbon 2.

In addition, according to an embodiment in the disclosure, the conductive coating layer is a conductive adhesive layer or a conductive pressure-sensitive adhesive layer. However, the conductive coating layer is not limited in the disclosure, as long as the conductive coating layer is made of a material having a melting point lower than the melting point of the alloy layer.

It should be noted that, the photovoltaic ribbon according to the embodiments in the disclosure, when used for producing a photovoltaic cell, can be welded by a welding equipment used for producing a photovoltaic cell in the conventional technology. Only the welding temperature and the welding time need to be adjusted as required, having a high compatibility with the welding process of the conventional technology.

Correspondingly, according to an embodiment, there is also provided a photovoltaic module including at least one photovoltaic cell according to any of the above embodiments to improve the photoelectric conversion efficiency, reducing the breakage rate and the production cost of the photovoltaic module and the photovoltaic cell.

Based on the above embodiment, in another embodiment, the photovoltaic module includes multiple photovoltaic cells, including a first photovoltaic cell and a second photovoltaic cell that are adjacent to each other. A photovoltaic ribbon on the front side of the first photovoltaic cell is electrically connected to a photovoltaic ribbon on the back side of the second photovoltaic cell, so that the first photovoltaic cell and the second photovoltaic cell are connected in series to increase the generated energy of the photovoltaic module.

In summary, the photovoltaic cell or module according to embodiments of the disclosure includes a cell slice 1 having a plurality of thin gate lines 11 on the front side; and a photovoltaic ribbon 2 disposed on a side of the thin gate lines 11 opposite to the photovoltaic cell slice and welded directly with the thin gate lines 11. The photovoltaic ribbon 2 includes: a metal substrate 21, such as a copper substrate 21; an alloy layer 22 disposed on the surface of the copper substrate 21 and covering the copper substrate 21; and a conductive coating layer 23 disposed on the surface of the alloy layer 22 and covering the alloy layer 22. The conductive coating layer 23 is directly welded with the thin gate lines 11. The melting point of the conductive coating layer 23 is lower than the melting point of the alloy layer, so that the photovoltaic module/cell according to the embodiments may omit the main gate line. Therefore, the thin gate lines 11 are electrically connected to the photovoltaic ribbon 2 by welding directly the thin gate lines 11 to the photovoltaic ribbon 2, and the current in individual thin gate lines 11 are assembled directly via the photovoltaic ribbon 2, thus reducing the shading area of the photovoltaic cell and increasing the light-receiving area of the photovoltaic cell, and whereby improving the photoelectric conversion efficiency of the photovoltaic cell.

In addition, the photovoltaic ribbon 2 according to embodiment of the disclosure includes the three layers: the copper substrate 1, the alloy layer 2 and the conductive coating layer 3. The copper substrate 1 is for current transmission, the alloy layer 2 is for ensuring a good contact between the copper substrate 1 and the conductive coating layer 3, and the conductive coating layer 3 is for welding to the gate lines on the surface of the photovoltaic cell. The melting point of the conductive coating layer, for example, is lower than the melting point of the alloy layer. Thus, compared with the photovoltaic ribbon in the conventional technology, the photovoltaic ribbon according to the embodiment has a lower welding temperature, reducing the temperature difference between the welded portion and the non-welded portion in the welding process, and thereby decreasing the breakage rate and the production cost of photovoltaic cells.

Moreover, since the main gate line is eliminated in the photovoltaic cell according to embodiments of the disclosure, the corresponding amount of sliver paste for the main gate line can be avoided, reducing the amount of the sliver paste used in producing the photovoltaic cell, and further reducing the production cost of the photovoltaic cell.

The description of the embodiments herein enables those skilled in the art to implement or use the present disclosure. Numerous modifications to the embodiments will be apparent to those skilled in the art, and the general principle herein can be implemented in other embodiments without deviation from the spirit or scope of the present disclosure. Therefore, the present disclosure will not be limited to the embodiments described herein, but in accordance with the widest scope consistent with the principle and novel features disclosed herein.

## Claims

1. A photovoltaic module, comprising:
a cell slice having a plurality of thin gate lines on a side; and
a photovoltaic ribbon, comprising a metal substrate, a conductive coating layer and an alloy layer that is sandwiched between the metal substrate and the conductive coating layer,
wherein the conductive coating layer of the photovoltaic ribbon is in direct contact with the thin gate lines.

2. The photovoltaic module according to claim 1, wherein the conductive coating layer has a melting point lower than that of the alloy layer.

3. The photovoltaic module according to claim 1, wherein the photovoltaic ribbon is in contact with the thin gate lines by means of welding at a temperature equal to or greater than 160°C and less than or equal to 180°C.

4. The photovoltaic module according to claim 1, wherein the photovoltaic ribbon has a width which is equal to or greater than 1.0mm and less than or equal to 1.5mm.

5. The photovoltaic module according to claim 1, wherein the alloy layer has a width which is equal to or greater than 0.02mm and less than or equal to 0.03mm.

6. The photovoltaic module according to claim 1, wherein the conductive coating layer has a width which is equal to or greater than 0.01mm and less than or equal to 0.02mm.

7. The photovoltaic module according to claim 1, wherein the cell slice comprises a first cell slice and a second cell slice, which are electrically connected to each other through the photovoltaic ribbon.

8. The photovoltaic module according to claim 7, wherein each of the first cell slice and the second cell slice has a back surface field and/or back electrode on another side, and the conductive coating layer of the photovoltaic ribbon is in direct contact with the thin gate lines of the first cell slice and the back surface field and/or back electrode of the second cell slice.

9. The photovoltaic module according to claim 1, wherein the metal substrate comprises a copper substrate.

10. A method for producing a photovoltaic module, comprising:
providing a cell slice having a plurality of thin gate lines on a side; and
providing a photovoltaic ribbon, comprising a metal substrate, a conductive coating layer and an alloy layer that is sandwiched between the metal substrate and the conductive coating layer;
sticking the conductive coating layer to the thin gate lines; and
melting the conductive coating layer to weld the photovoltaic ribbon.

11. The method according to claim 10, wherein the conductive coating layer has a melting point lower than that of the alloy layer.

12. The method according to claim 10, wherein the welding is performed at a temperature equal to or greater than 160°C and less than or equal to 180°C.

13. The method according to claim 10, wherein the conductive coating layer has a width which is equal to or greater than 0.01mm and less than or equal to 0.02mm.

14. The method according to claim 10, wherein the cell slice comprises a first cell slice and a second cell slice, and the method further comprises electrically connecting the first cell slice and the second cell slice through the photovoltaic ribbon.

15. The method according to claim 14, wherein each of the first cell slice and the second cell slice has a back surface field and/or back electrode on another side, and the conductive coating layer of the photovoltaic ribbon is in direct contact with the thin gate lines of the first cell slice and the back surface field and/or back electrode of the second cell slice.
